# FASCICULE DE BREVET EUROPEEN

(11) **EP 0 851 503 B1**
(45) Date de publication et mention de la délivrance du brevet: **25.08.2004**
(21) Numéro de dépôt: 97403141.1
(22) Date de dépôt: 23.12.1997
(51) Int. Cl.: H01L 27/146, H01L 31/0232, H01L 31/0216

(54) **Détecteur d'image à contraste amelioré**
Bildsensor mit verbessertem Kontrast
Image detector with improved contrast

(30) Priorité: 27.12.1996 FR 9616110
(43) Date de publication de la demande: 01.07.1998
(73) Titulaire: THALES ELECTRON DEVICES S.A., 78140 Vélizy (FR)
(72) Inventeur: Moy, Jean-Pierre, 94117 Arcueil Cedex (FR); Ducourant, Thierry, 94117 Arcueil Cedex (FR)
(74) Mandataire: Guérin, Michel

(56) Documents cités:
- DE-A- 4 433 132
- US-A- 4 980 553
- US-A- 5 036 203
- US-A- 5 294 288
- US-A- 5 422 489

## Description

La présente invention concerne les détecteurs d'image du type dans lequel une matrice d'éléments photosensibles est associée à une source de lumière additionnelle. L'invention s'applique de manière particulièrement intéressante dans le cas de la détection des images radiologiques.

On trouve maintenant couramment des panneaux détecteurs d'image de grandes dimensions, utilisant des matrices de points photosensibles en matériaux semi-conducteurs, réalisés notamment par des technique de dépôt de films en couches minces. Le plus souvent, les points photosensibles sont constitués à partir de silicium amorphe. Ils comprennent chacun un élément photosensible (une photodiode par exemple), associé à un élément interrupteur constitué par un transistor ou par une diode dite de commutation.

Les points photosensibles forment un réseau de lignes et de colonnes. La commande de chacun des éléments interrupteurs, ligne par ligne, permet de transférer sur une colonne les charges produites par la photodiode correspondante durant l'exposition de cette dernière à un signal lumineux de mesure, c'est à dire à un signal correspondant à une image à détecter. Des circuits de multiplexage extérieurs permettent ensuite de lire les charges des différents points photosensibles.

Une matrice photosensible du type ci-dessus indiqué, ainsi que son mode de fonctionnement et une manière de la réaliser, sont décrits notamment dans une demande de brevet français n° 86.14.058 (n° de publication 2.605.166).

Un autre type de détecteur est décrit dans le brevet US 5 036 203 ; il s'agit d'un détecteur infra-rouge bi-énergie comportant des premiers et seconds éléments détecteurs respectivement sensibles à une première et une seconde bande de longueur d'onde.

Pour la détection des images radiologiques, il suffit d'interposer un scintillateur entre la matrice photosensible et le rayonnement X, pour convertir le rayonnement X en un rayonnement lumineux visible ou proche du visible auquel sont sensibles les photodiodes. Il est classique à cet effet, de recouvrir les éléments photosensibles de la matrice par une couche d'une substance scintillatrice, par exemple de l'iodure de césium dopé au thallium.

Il existe différents procédés de commande du fonctionnement des matrices photosensibles, qui dépendent notamment des buts particulièrement visés, de l'organisation générale de la matrice ainsi que de la constitution des points photosensibles.

Certains de ces procédés de commande utilisent un éclairement additionnel des points photosensibles, à l'aide d'une source lumineuse additionnelle ; cette dernière produit un faisceau de lumière additionnelle (appelé "rayonnement additionnel" dans la suite de la description) indépendant du signal lumineux de mesure correspondant à une image à détecter. Ce cas est assez fréquent, particulièrement quand les points photosensibles sont constitués chacun par une photodiode montée en série avec une diode de commutation. En effet dans cas, l'exposition des points photosensibles à un rayonnement additionnel, constitue un moyen relativement simple d'intervenir sur la valeur d'une tension présente au point de jonction de la photodiode et de la diode de commutation, dans chacun des points photosensibles.

Cette exposition des points photosensibles au rayonnement additionnel, peut constituer ce qui est appelé une remise à niveau optique. Elle est effectuée généralement dans une phase du procédé qui précède celle de l'exposition au signal utile de mesure. Une telle opération de remise à niveau optique est décrite dans la demande de brevet n° 86.14.058 déjà citée plus haut.

Il est connu d'autres procédés de fonctionnement dans lesquels un éclairement additionnel de la matrice photosensible est accompli, dans le but de créer des charges dites d'entraînement, dans chacun des points photosensibles. Un tel procédé de fonctionnement est décrit dans la demande de brevet français n° 88. 12126 publié avec le n° 2.636.800. Dans ce fonctionnement, pour chaque point photosensible, des charges d'entraînement sont ajoutées aux charges "signal" produites par le signal lumineux de mesure, dans le but d'améliorer l'efficacité du transfert de ces charges pour les faibles valeurs du signal.

Quelles que soient les raisons d'exposer la matrice photosensible au rayonnement additionnel, la source lumineuse additionnelle (appelée "source additionnelle " dans la suite de la description) qui produit ce rayonnement, est disposée généralement sur une face arrière du support de la matrice photosensible, c'est à dire sur une face opposée à celle sur laquelle est réalisée la matrice. Une telle disposition est rendue possible grâce à la transparence du support, support qui généralement est en verre. Par suite, le niveau de transparence du support revêt une grande importance, car plus ce niveau de transparence est élevé et plus il permet, pour un même résultat, d'émettre le rayonnement additionnel avec une puissance plus faible, et donc pour un encombrement et un coût plus faibles de la source de rayonnement additionnel.

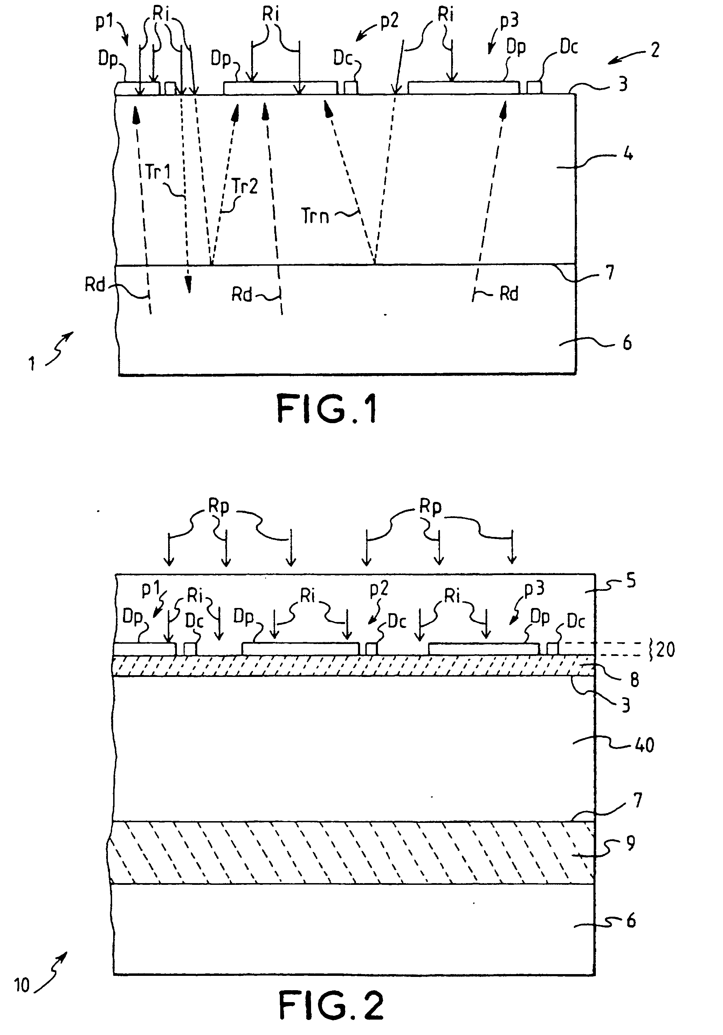

Cependant, cette transparence du support utile à l'éclairement additionnel, peut aussi présenter un inconvénient sérieux qui est davantage expliqué en référence à la figure 1.

La figure 1 représente de façon schématique par une vue en coupe (parallèlement à une ligne de points photosensibles par exemple), la structure d'un panneau détecteur d'image 1 classique du type ci-dessus défini. Le détecteur d'image comporte une matrice 2 de points photosensibles p1, p2, p3, constitués chacun dans l'exemple, par une diode de commutation Dc associée à une photodiode Dp. La matrice photosensible 2 est réalisée sur une première face 3 d'un support ou substrat 4, transparent, en verre par exemple. Le détecteur d'image 1 comporte en outre une source additionnelle 6, appliquée sur la seconde face ou face arrière 7 du support 4, à l'opposé de la matrice photosensible 2. La source additionnelle 6 produit (à l'aide par exemple de diodes photoémissives, non représentées), un rayonnement constituant le rayonnement additionnel ci-dessus mentionné, destiné par exemple à réaliser une remise à niveau optique.

La matrice photosensible 2 est éclairée par un rayonnement dit incident représenté par des rayons Ri, rayonnement qui constitue le signal lumineux de mesure. La lumière incidente à détecter n'est en général pas entièrement absorbée par les points photosensibles p1, p2, p3 : en effet, une petite partie du rayonnement incident Ri traverse le matériau actif de ces points photosensibles (silicium amorphe des photodiodes Dp) sans être absorbé ; une autre partie traverse le panneau détecteur 1, entre les photodiodes dans les espaces libres entre connexions (non représentées).

Après la traversée du substrat 4 en verre, comme illustré sur la figure 1 par des trajectoires tr1, tr2, ..., trn, cette fraction de la lumière incidente qui n'a pas été absorbée et donc pas détectée, est réfléchie ou diffusée de façon incontrôlable. Cette fraction de lumière constitue alors une lumière parasite, qui peut finalement être détectée par d'autres points photosensibles que ceux à proximité desquels ou dans lesquels elle est passée, et plus particulièrement par des points qui en sont éloignés. La source additionnelle 6 est représentée appliquée contre le substrat 4. On pourrait envisager qu'un espace libre les sépare. Son épaisseur peut être d'un ou plusieurs millimètres voire d'un ou plusieurs centimètres. Cet espace forme avec le substrat un dioptre substrat-air. De la lumière peut se propager dans cet espace.

Le résultat global est une perte de contraste, particulièrement prononcée aux basses fréquences spatiales.

Le brevet US 4 980 553 décrit un détecteur d'image avec une matrice de points photosensibles et une source additionnelle. Mais un tel détecteur ne permet pas d'améliorer le contraste.

Une solution visant à réduire le niveau de cette lumière parasite, inspirée de techniques utilisées dans le domaine des intensificateurs d'image, consiste à utiliser un support moins transparent, ayant une transmission T. Dans ce cas, la lumière non détectée doit traverser deux fois le support pour être captée par un point photosensible, et en conséquence elle est atténuée par un facteur T². On peut ainsi rendre négligeable la lumière parasite. Cette solution a comme inconvénient notamment, que le rayonnement additionnel doit être 1/T fois plus puissant pour réaliser sa fonction.

La présente invention a pour but de réduire la perte de contraste ci-dessus mentionnée, sans pour autant devoir modifier la puissance émise du rayonnement additionnel.

Suivant l'invention, un système comprendant un détecteur d'image comportant une matrice de points photosensibles, un support sur lequel est réalisée la matrice photosensible, une source dite additionnelle produisant un rayonnement additionnel, la source additionnelle étant disposée du côté d'une face du support opposée à la face qui porte la matrice photosensible, la matrice photosensible étant exposée à ce rayonnement dit incident, une partie du rayonnement incident n'étant pas détectée par la matrice photosensible, le détecteur comportant en outre des moyens pour favoriser la transmission du rayonnement additionnel, entre la source additionnelle et la matrice photosensible, par rapport à la partie non détectée du rayonnement incident et pour éviter la réflexion ou la diffusion incontrôlable de la partie non détectée du rayonnement incident, et en ce que le rayonnement incident et le rayonnement additionnel correspondent à des bandes de longueurs d'ondes différentes.

L'invention sera mieux comprise et d'autres avantages qu'elle présente apparaîtront à la lecture de la description qui suit de certains de ces modes de réalisations, description faite à titre d'exemple non limitatif en référence aux dessins annexés dans lesquels :
- la figure 1 déjà décrite représente une structure classique de détecteur d'image ;
- la figure 2 représente la structure d'un détecteur d'image conforme à l'invention.

A la figure 2, on a représenté la structure d'un détecteur d'image 10 suivant l'invention, par une vue en coupe semblable à celle de la figure 1. Le détecteur 10 comporte une matrice 20 de points photosensibles p1, p2, p3 d'un même type que ceux de la matrice 2 montrée à la figure 1. Comme dans le cas de la figure 1, la matrice 20 est réalisée sur la face 3 d'un support 40. Le détecteur 10 comporte une source additionnelle 6 du côté de sa face arrière 7. Cette source additionnelle peut être pour exemple d'un même type que celle de la figure 1. Un espace libre peut ici encore séparer le substrat 40 de la source additionnelle 6. La source additionnelle 6 est destinée à produire un rayonnement additionnel Rd (non représenté à la figure 2), en vue par exemple d'opérer une remise à niveau optique.

Dans l'exemple représenté, le détecteur 10 étant destiné à la détection d'images radiologiques, il comporte en plus par rapport au détecteur 1 de la figure 1, un scintillateur constitué par une couche 5 recouvrant la matrice 20 et donc les points photosensibles p1, p2, p3. Le scintillateur 5 reçoit un rayonnement primaire Rp, soit un rayonnement X dans l'exemple, qu'il convertit en un rayonnement incident Ri éclairant la matrice photosensible 20 et correspondant à une bande de longueurs d'onde auxquelles sont sensibles les photodiodes Dp.

Suivant une caractéristique de l'invention, on choisit la substance scintillatrice du scintillateur 5 et/ ou la source additionnelle 6, pour que l'émission du rayonnement incident Ri par le scintillateur 5, et l'émission d'un rayonnement additionnel Rd par la source additionnelle 6, s'effectuent à des longueurs d'onde différentes ou, plus précisément, correspondent à des bandes de longueurs d'onde différentes.

Suivant une autre caractéristique de l'invention, cette différence de bandes de longueurs d'onde est combinée à un élément sélectif en longueurs d'onde, permettant de favoriser la transmission du rayonnement additionnel Rd, par rapport à une partie (non représentée sur la figure 2) de la lumière incidente Ri non détectée par la matrice 20 photosensible.

Ainsi par exemple, dans cette première version de l'invention, d'une part, avec un scintillateur 5 en iodure de césium dopé au thallium, le rayonnement X ou rayonnement primaire Rp est converti en lumière visible principalement verte, centrée sur 550 nanomètres ; et d'autre part, la remise à niveau optique peut se faire avantageusement en lumière rouge, et le rayonnement additionnel Rd peut donc être centré vers 650 nanomètres. En effet, le silicium amorphe est sensible à ces longueurs d'onde et plus transparent, ce qui permet une remise à niveau efficace dans toute son épaisseur. De plus il existe des diodes photoémissives rouges efficaces et de faible coût.

En ce qui concerne l'élément de transmission sélectif en longueurs d'onde, ce dernier peut être constitué de différentes manières, dont certaines sont décrites ci-dessous.

L'élément de transmission sélectif en longueurs d'onde peut être constitué par le support 40 lui-même. En effet le support 40 peut être rendu absorbant, dans le vert dans l'exemple, avec une bonne transmission dans le rouge, par exemple par une simple coloration en rouge du verre dont il est constitué. Dans ce cas, la partie non détectée du rayonnement incident Ri est absorbée par le support 40, et ne peut donc plus atteindre d'autres points photosensibles.

Il est à noter qu'un tel résultat est également obtenu pour des rayonnements incidents et additionnels Ri, Rd ayant des longueurs d'onde différentes, dès lors que le support 40 est coloré pour correspondre sensiblement à la longueur d'onde centrale du rayonnement additionnel : par exemple, pour un rayonnement incident Ri centré (au contraire du premier exemple) vers 650 nm, et un rayonnement additionnel Rd centré sur 550nm, le support 40 devra être coloré en vert.

Dans un autre mode de réalisation, l'élément de transmission sélectif en longueur d'onde est constitué par une couche dichroïque 8, du type multidiélectrique par exemple, destinée d'une part à transmettre les longueurs d'onde qui correspondent au rayonnement additionnel Rd, et d'autre part à réfléchir la partie non détectée du rayonnement incident Ri. C'est à dire dans le cas du premier exemple indiqué ci-dessus, cette couche dichroïque 8 est transparente à 650 nm et réfléchissante à 550 nm. La couche dichroïque 8 est située entre la matrice 20, et le support 40, sur lequel elle est déposée avant la matrice 20.

Il et à remarquer que la solution ci-dessus présentée, bien que peut être un peu onéreuse en fabrication, présente l'avantage d'augmenter l'efficacité de détection des photodiodes Dp.

Enfin, dans un mode de réalisation avantageux sur le plan de l'industrialisation, l'élément de transmission sélectif en longueurs d'onde est une couche colorée 9, disposée entre le support 40 et la source additionnelle 6.

La couche colorée 9 a pour fonction d'absorber la partie non détectée du rayonnement incident Ri (après que celle-ci a traversé le support 40), et de transmettre le rayonnement additionnel Rd produit par la source additionnelle 6. A cet effet, dans le cas du premier exemple cité plus haut, cette couche colorée 9 est absorbante autour 550 nm, et elle est transparente vers 650 nm (soit colorée rouge).

La couche colorée 9 doit être en un matériau ayant un indice de réfraction aussi proche que possible de celui du support 40. A cette fin cette couche 9 peut être par exemple un vernis, ou bien une feuille de polymère collée ou laminée sur la face arrière 7 du support 40. La couche 9 peut aussi être constituée par une plaque de verre coloré. La colle devra également être choisie avec un indice de réfraction proche de celui du support 40, en verre dans l'exemple, ou bien intermédiaire entre les indices présentés par le support 40 et par le matériau qui constitue la couche colorée.

L'adaptation des indices a pour but d'éviter les réflexions sur le dioptre constitué à l'interface 9-40, entre la couche colorée 9 et le support 40. Cependant cette adaptation n'est pas critique : en effet, une différence d'indice de 0,1 (par exemple 1,4 et 1,5) se traduit par un coefficient de réflexion de 0,001 à l'incidence normale.

La forme de réalisation de invention utilisant la couche colorée 9 est industriellement intéressante, en ce qu'elle ne perturbe pas la réalisation du panneau détecteur 10, réalisation qui notamment nécessite des traitements chimiques et thermiques agressifs. Elle est relativement peu coûteuse et se prête facilement à une fabrication en grand nombre.

Bien entendu, il est possible aussi d'utiliser simultanément les différents modes de réalisations de l'élément de transmission sélectif en longueurs d'onde 40, 8, 9. Cet élément de transmission sélectif 40, 8, 9, est en fait un filtre sélectif en longueurs d'onde qui d'une part, dans les trois cas, doit transmettre le rayonnement additionnel Rd avec l'atténuation la plus faible possible, et d'autre part doit absorber au maximum le rayonnement incident Ri, sauf dans la version de l'élément de transmission 8 (couche dichroïque) où ce rayonnement incident est réfléchi. Il n'y a donc pas d'incompatibilité entre les trois éléments de transmission sélectifs en longueurs d'onde.

Les explications qui précèdent se rapportent au cas dans lequel les longueurs d'ondes du rayonnement incident Ri et celles du rayonnement additionnel Rd sont différentes, et sont contenues dans des bandes relativement éloignées l'une de l'autre.

Mais l'invention peut s'appliquer dans des configurations différentes. Elle peut s'appliquer de manière avantageuse même dans le cas où le rayonnement incident Ri et le rayonnement additionnel Rd ont des bandes de longueurs d'onde centrées sur une même longueur d'onde, à la condition que la bande de longueurs d'onde du rayonnement additionnel soit plus étroite que celle du rayonnement incident Ri.

Dans un tel cas en effet, la partie du rayonnement incident Ri susceptible d'être transmise par l'élément de transmission sélectif en longueurs d'onde 40, 8, 9 ne constitue qu'une faible fraction de la partie non détectée du rayonnement incident Ri. Cette fraction peut être d'autant plus faible que dans un tel cas, la source additionnelle 6 peut être d'un type comportant des éléments en eux-mêmes classiques, capables de produire le rayonnement additionnel Rd dans une bande de longueur d'onde très étroite : en conséquence on peut utiliser des éléments de transmission sélectifs en longueur d'onde qui favorisent la transmission d'une bande de longueurs d'onde elle-même très étroite. Avec par exemple un élément de transmission sélectif du type de la couche dichroïque 8, il est possible de limiter cette transmission à une bande particulièrement étroite.

Dans l'exemple non limitatif montré à la figure 2, le détecteur d'image 10 comporte un scintillateur 5 lui permettant de convertir le rayonnement primaire Rp en un rayonnement lumineux formant le rayonnement incident Ri, adapté à la sensibilité de la matrice photosensible 20 (le rayonnement primaire Rp étant un rayonnement X comme indiqué plus haut). Il convient d'observer d'une part, que le scintillateur 5 peut être de différentes natures (iodure de césium, oxyde de gadolinium, etc.), et d'autre part que le rayonnement primaire Rp peut lui aussi être de nature différente, par exemple rayonnement gamma, ou neutronique, etc.

Il est à observer en outre, que le rayonnement primaire Rp peut également avoir des longueurs d'onde comprises dans la bande de longueurs d'onde de sensibilité de la matrice 20 ; dans ce cas, il constitue directement le rayonnement incident Ri, et le scintillateur 5 n'est pas nécessaire.

L'invention peut s'appliquer également de manière avantageuse quand le rayonnement primaire constitue directement le rayonnement incident Ri, c'est à dire en l'absence du scintillateur 5. Dans un tel cas en effet, en supposant que le rayonnement incident Ri, Rp par lequel est éclairée la matrice photosensible 20, s'effectue dans une bande de longueurs d'onde correspondant à la lumière visible, le rayonnement additionnel Rd servant à la remise à niveau optique peut être constitué par des longueurs d'onde contenues dans la bande de la lumière visible, mais formant une bande beaucoup plus étroite que cette dernière. Dans ces conditions, l'élément de transmission sélectif en longueurs d'onde 40, 8, 9 transmet suivant sa fonction, le rayonnement additionnel Rd, plus une lumière correspondant à une fraction de la partie non détectée (par la matrice 20 photosensible) du rayonnement incident Ri ; cette fraction étant d'autant plus faible que la bande de transmission de l'élément sélectif 40, 8, 9 est étroite, et que la bande en longueurs d'onde du rayonnement incident Ri est étendue.

Bien entendu, dans cette configuration où le rayonnement primaire Rp constitue directement le rayonnement incident Ri, l'invention s'applique avantageusement aussi, comme dans la version avec scintillateur, au cas dans lequel les longueurs d'onde du rayonnement additionnel Rd ne coïncident pas ou peu avec celles du rayonnement incident Ri. Par exemple, la bande de longueurs d'onde du rayonnement additionnel Rd peut se situer dans le proche infrarouge, auquel sont sensibles les points photosensibles p1, p2, p3 réalisés en matériau semi-conducteur, en silicium amorphe par exemple. Il est à noter que la bande en longueurs d'onde du rayonnement additionnel Rd peut se situer aussi à l'opposé, c'est à dire dans l'ultraviolet.

## Revendications

1. Système comprendant un détecteur d'image comportant une matrice (20) de points photosensibles (p1, p2, p3) exposée à un rayonnement dit incident (Ri), un support (40) sur lequel est réalisée la matrice (20) photosensible, une source dite additionnelle (6) produisant un rayonnement additionnel (Rd), la source additionnelle (6) étant disposée du côté d'une face (7) du support opposée à une face (3) qui porte la matrice photosensible (20), la matrice photosensible (20) étant exposée à ce rayonnement incident (Ri) dont une partie n'est pas détectée par la matrice photosensible (20), le détecteur comportant en outre des moyens (40, 8, 9) pour favoriser la transmission du rayonnement additionnel (Rd), entre la source additionnelle (6) et la matrice (20), par rapport à la partie non détectée du rayonnement incident (Ri) et pour éviter la réflexion ou la diffusion incontrôlable de la partie non détectée du rayonnement incident (Ri), et en ce que le rayonnement incident (Ri) et le rayonnement additionnel (Rd) correspondent à des bandes de longueurs d'ondes différentes.

2. Détecteur d'image suivant la revendication précédente, **caractérisé en ce que** le rayonnement additionnel (Rd) et le rayonnement incident (Ri) sont émis respectivement dans une première et une seconde bande de longueurs d'onde, et **en ce que** les deux bandes sont centrées sur des longueurs d'onde différentes.

3. Détecteur d'image suivant la revendication 1, **caractérisé en ce que** le rayonnement additionnel (Rd) et le rayonnement incident (Ri) sont émis respectivement dans une première et une seconde bande de longueurs d'onde, et **en ce que** la première bande est centrée sur une longueur d'onde comprise dans la seconde bande de longueurs d'onde.

4. Détecteur d'image suivant l'une des revendications précédentes, **caractérisé en ce que** le rayonnement additionnel (Rd) est émis dans une bande de longueurs d'onde plus étroite que la bande de longueurs d'onde du rayonnement incident (Ri).

5. Détecteur d'image suivant l'une des revendications précédentes, **caractérisé en ce qu'**il comporte au moins un élément de transmission (40, 8, 9) sélectif en longueurs d'onde, permettant de favoriser la transmission du rayonnement additionnel (Rd).

6. Détecteur d'image suivant la revendication 5, **caractérisé en ce que** l'élément de transmission sélectif en longueurs d'onde est constitué par une coloration du support (40).

7. Détecteur d'image suivant la revendication 6, **caractérisé en ce que** la coloration du support (40) correspond sensiblement à une longueur d'onde centrale du rayonnement additionnel (Rd).

8. Détecteur d'image suivant la revendication 5, **caractérisé en ce que** l'élément de transmission sélectif en longueurs d'onde est constitué par une couche dichroïque (8), transparente pour des longueurs d'onde correspondant au rayonnement additionnel (Rd), et réfléchissante pour au moins les longueurs d'onde correspondant au rayonnement incident (Ri).

9. Détecteur d'image suivant la revendication 8, **caractérisé en ce que** la couche dichroïque (8) est une couche du type multidiélectrique.

10. Détecteur d'image suivant l'une quelconque des revendications 5 ou 8 ou 9, **caractérisé en ce que** l'élément de transmission sélectif en longueurs d'onde (8) est disposé entre la matrice (20) photosensible et le support (40).

11. Détecteur d'image suivant la revendication 5, **caractérisé en ce que** l'élément de transmission sélectif en longueurs d'onde est constitué par une couche colorée (9), disposée entre le support (40) et la source additionnelle (6), la coloration de ladite couche colorée (9) correspondant sensiblement à une longueur d'onde centrale du rayonnement additionnel (Rd).

12. Détecteur d'image suivant la revendication 11, **caractérisé en ce que** la couche colorée (9) est constituée par un vernis.

13. Détecteur d'image suivant la revendication 11, **caractérisé en ce que** la couche colorée (9) est constituée par une feuille de polymère.

14. Détecteur d'image suivant la revendication 11, **caractérisé en ce que** la couche colorée (9) est constituée par une plaque de verre.

15. Détecteur d'image suivant l'une des revendications précédentes, **caractérisé en ce que**, en vue d'une application en radiologie, il comporte un scintillateur (5) pour convertir un rayonnement X (ou gamma, ou neutronique, etc.) en un rayonnement dit incident (Ri) dans la bande de longueurs d'onde auxquelles sont sensibles les points photosensibles (p1, p2, p3).

16. Détecteur d'image suivant la revendication 15, **caractérisé en ce que** le scintillateur (5) est de l'iodure de césium dopé au thallium (Csl:Tl), et **en ce que** le rayonnement additionnel (Rd) s'effectue dans une bande de longueurs d'onde sensiblement centrée sur 650 nanomètres.

17. Détecteur d'image suivant l'une des revendications précédentes, **caractérisé en ce que** les points photosensibles (p1, p2, p3) sont constituées à partir d'un matériau semi-conducteur.

18. Détecteur d'image suivant la revendication 17, **caractérisé en ce que** le matériau semi-conducteur est du silicium amorphe.

## Patentansprüche

1. System, das einen Bildsensor mit einer Matrix (20) photosensibler Punkte (p1, p2, p3) umfasst, die mit einer so genannten einfallenden Strahlung (Ri) exponiert sind, einem Träger (40), auf dem die photosensible Matrix (20) hergestellt ist, einer so genannten zusätzlichen Quelle (6), die eine zusätzliche Strahlung (Rd) erzeugt, wobei die zusätzliche Quelle (6) auf der Seite einer Fläche (7) des Trägers angeordnet ist, die einer Fläche (3) gegenüber liegt, die die photosensible Matrix (20) trägt, wobei die photosensible Matrix (20) mit dieser einfallenden Strahlung (Ri), von der ein Teil von der photosensiblen Matrix (20) nicht erfasst wird, exponiert ist, wobei der Bildsensor ferner Mittel (40, 8, 9) umfasst, um die Übertragung der zusätzlichen Strahlung (Rd) zwischen der zusätzlichen Quelle (6) und der Matrix (20) im Vergleich zu dem nicht erfassten Teil der einfallenden Strahlung (Ri) zu begünstigen, und um die Reflexion oder die unkontrollierbare Diffusion des nicht erfassten Teils der einfallenden Strahlung (Ri) zu vermeiden, und dadurch, dass die einfallende Strahlung (Ri) und die zusätzliche Strahlung (Rd) unterschiedlichen Spektralbändern entsprechen.

2. Bildsensor nach dem vorhergehenden Anspruch, **dadurch gekennzeichnet, dass** die zusätzliche Strahlung (Rd) und die einfallende Strahlung (Ri) jeweils in einem ersten und einem zweiten Spektralband gesendet werden und dadurch, dass die zwei Bänder auf unterschiedliche Wellenlängen zentriert sind.

3. Bildsensor nach Anspruch 1, **dadurch gekennzeichnet, dass** die zusätzliche Strahlung (Rd) und die einfallende Strahlung (Ri) jeweils in einem ersten und einem zweiten Spektralband gesendet werden, und dadurch, dass das erste Band auf eine Wellenlänge zentriert ist, die im zweiten Spektralband enthalten ist.

4. Bildsensor nach einem der vorhergehenden Ansprüche, **dadurch gekennzeichnet, dass** die zusätzliche Strahlung (Rd) in einem Spektralband gesendet wird, das schmaler ist als das Spektralband der einfallenden Strahlung (Ri).

5. Bildsensor nach einem der vorhergehenden Ansprüche, **dadurch gekennzeichnet, dass** er mindestens ein in Wellenlängen selektives Übertragungselement (40, 8, 9) umfasst, das es erlaubt, die Übertragung der zusätzlichen Strahlung (Rd) zu begünstigen.

6. Bildsensor nach Anspruch 5, **dadurch gekennzeichnet, dass** das in Wellenlängen selektive Übertragungselement aus einer Färbung des Trägers (40) besteht.

7. Bildsensor nach Anspruch 6, **dadurch gekennzeichnet, dass** die Färbung des Trägers (40) im Wesentlichen einer zentralen Wellenlänge der zusätzlichen Strahlung (Rd) entspricht.

8. Bildsensor nach Anspruch 5, **dadurch gekennzeichnet, dass** das in Wellenlängen selektive Übertragungselement aus einer dichroitischen Schicht (8) besteht, die für Wellenlängen transparent ist, die der zusätzlichen Strahlung (Rd) entsprechen und für mindestens die Wellenlängen, die der einfallenden Strahlung (Ri) entsprechen, reflektierend ist.

9. Bildsensor nach Anspruch 8, **dadurch gekennzeichnet, dass** die dichroitische Schicht (8) eine Schicht des multidielektrischen Typs ist.

10. Bildsensor nach einem der Ansprüche 5 oder 8 oder 9, **dadurch gekennzeichnet, dass** das in Wellenlängen selektive Übertragungselement (8) zwischen der photosensiblen Matrix (20) und dem Träger (40) angeordnet ist.

11. Bildsensor nach Anspruch 5, **dadurch gekennzeichnet, dass** das in Wellenlängen selektive Übertragungselement aus einer gefärbten Schicht (9) besteht, die zwischen dem Träger (40) und der zusätzlichen Quelle (6) angeordnet ist, wobei die Färbung der gefärbten Schicht (9) im Wesentlichen einer zentralen Wellenlänge der zusätzlichen Strahlung (Rd) entspricht.

12. Bildsensor nach Anspruch 11, **dadurch gekennzeichnet, dass** die gefärbte Schicht (9) aus einem Lack besteht.

13. Bildsensor nach Anspruch 11, **dadurch gekennzeichnet, dass** die gefärbte Schicht (9) aus einem Polymerblatt besteht.

14. Bildsensor nach Anspruch 11, **dadurch gekennzeichnet, dass** die gefärbte Schicht (9) aus einer Glasplatte besteht.

15. Bildsensor nach einem der vorhergehenden Ansprüche, **dadurch gekennzeichnet, dass** er zur Anwendung in der Radiologie einen Scintillator (5) umfasst, um eine Röntgenstrahlung (oder Gammaoder Neutronenstrahlung usw.) in eine so genannte einfallende Strahlung (Ri) im Spektralband, in dem die photosensiblen Punkte (p1, p2, p3) sensibel sind, umzuwandeln.

16. Bildsensor nach Anspruch 15, **dadurch gekennzeichnet, dass** der Scintillator (5) Cäsiumiodid geimpft mit Thallium (Csl:TI) ist, und dadurch, dass die zusätzliche Strahlung (Rd) in einem im Wesentlichen auf 650 Nanometer zentrierten Spektralband erfolgt.

17. Bildsensor nach einem der vorhergehenden Ansprüche, **dadurch gekennzeichnet, dass** die photosensiblen Punkte (p1, p2, p3) ausgehend von einem Halbleiterwerkstoff gebildet werden.

18. Bildsensor nach Anspruch 17, **dadurch gekennzeichnet, dass** der Halbleiterwerkstoff amorphes Silizium ist.

## Claims

1. System including an image detector comprising a matrix (20) of photosensitive pixels (p1, p2, p3) that is exposed to what is called incident radiation (Ri), a support (40) on which the photosensitive matrix (20) is produced, a source called an additional source (6) producing additional radiation (Rd), the additional source (6) being placed alongside an opposite face (7) of the support to a face (3) that bears the photosensitive matrix (20), the photosensitive matrix (20) being exposed to this incident radiation (Ri), a part of which is not detected by the photosensitive matrix (20), the detector furthermore comprising means (40, 8, 9) for promoting transmission of the additional radiation (Rd), between the additional source (6) and the matrix (20), relative to the undetected part of the incident radiation (Ri), and for preventing uncontrollable reflection or scattering of the undetected part of the incident radiation (Ri), and the incident radiation (Ri) and the additional radiation (Rd) corresponding to different wavelength bands.

2. Image detector according to the preceding claim, **characterized in that** the additional radiation (Rd) and the incident radiation (Ri) are emitted in a first wavelength band and a second wavelength band, respectively, and **in that** the two bands are centred on different wavelengths.

3. Image detector according to Claim 1, **characterized in that** the additional radiation (Rd) and the incident radiation (Ri) are emitted in a first wavelength band and a second wavelength band, respectively, and **in that** the first band is centred on a wavelength lying within the second wavelength band.

4. Image detector according to one of the preceding claims, **characterized in that** the additional radiation (Rd) is emitted in a narrower wavelength band than the wavelength band of the incident radiation (Ri).

5. Image detector according to one of the preceding claims, **characterized in that** it includes at least one wavelength-selective transmission component (40, 8, 9) for promoting transmission of the additional radiation (Rd).

6. Image detector according to Claim 5, **characterized in that** the wavelength-selective transmission component is formed by a coloration of the support (40).

7. Image detector according to Claim 6, **characterized in that** the coloration of the support (40) corresponds approximately to a central wavelength of the additional radiation (Rd).

8. Image detector according to Claim 5, **characterized in that** the wavelength-selective transmission component consists of a dichroic layer (8) that is transparent for wavelengths corresponding to the additional radiation (Rd) and reflective for at least the wavelengths corresponding to the incident radiation (Ri).

9. Image detector according to Claim 8, **characterized in that** the dichroic layer (8) is a multidielectric-type layer.

10. Image detector according to any one of Claims 5, 8 and 9, **characterized in that** the wavelength-selective transmission component (8) is placed between the photosensitive matrix (20) and the support (40).

11. Image detector according to Claim 5, **characterized in that** the wavelength-selective transmission component consists of a coloured layer (9), placed between the support (40) and the additional source (6), the coloration of the said coloured layer (9) corresponding approximately to a central wavelength of the additional radiation (Rd).

12. Image detector according to Claim 11, **characterized in that** the coloured layer (9) is formed by a varnish.

13. Image detector according to Claim 11, **characterized in that** the coloured layer (9) is formed by a sheet of polymer.

14. Image detector according to Claim 11, **characterized in that** the coloured layer (9) is formed by a glass plate.

15. Image detector according to one of the preceding claims, **characterized in that**, with a view to an application in radiology, it includes a scintillator (5) for converting X-radiation (or gamma, neutron or other radiation) into what is called incident radiation (Ri) in the band of wavelengths to which the photosensitive pixels (p1, p2, p3) are sensitive.

16. Image detector according to Claim 15, **characterized in that** the scintillator (5) is made of thallium-doped caesium iodide (Tl:CsI) and **in that** the additional radiation (Rd) occurs in a wavelength band approximately centred on 650 nanometres.

17. Image detector according to one of the preceding claims, **characterized in that** the photosensitive pixels (p1, p2, p3) are formed from a semiconductor material.

18. Image detector according to Claim 17, **characterized in that** the semiconductor material is amorphous silicon.
